# EUROPEAN PATENT SPECIFICATION

(11) **EP 1 488 450 B1**
(45) Date of publication and mention of the grant of the patent: **08.04.2015**
(21) Application number: 03737679.5
(22) Date of filing: 07.02.2003
(51) Int. Cl.: C30B 31/00, C30B 33/00, H01L 21/04, H01L 33/00

(54) **METHODS OF TREATING A SILICON CARBIDE SUBSTRATE FOR IMPROVED EPITAXIAL DEPOSITION AND RESULTING STRUCTURES AND DEVICES**
VERFAHREN ZUR BEHANDLUNG EINES SILIZIUMCARBIDSUBSTRATS FÜR VERBESSERTE EPITAXIALABLAGERUNG UND RESULTIERENDE STRUKTUREN UND VORRICHTUNGEN
PROCEDES DE TRAITEMENT D'UN SUBSTRAT DE CARBURE DE SILICIUM POUR DEPOT EPITAXIQUE AMELIORE ET STRUCTURES ET DISPOSITIFS OBTENUS

(30) Priority: 08.02.2002 US 355034 P
(43) Date of publication of application: 22.12.2004
(73) Proprietor: Cree, Inc., Durham, NC 27703 (US)
(72) Inventor: McCLURE, Davis, Andrew, Cary, NC 27513 (US); SUVOROV, Alexander, Durham, NC 27713 (US); EDMOND, John, Adam, Cary, NC 27511 (US); SLATER, David, Beardsley, Jr., Durham, NC 27703 (US)
(74) Representative: Boult Wade Tennant
(86) International application number: PCT/US2003/003602
(87) International publication number: WO 2003/067637

(56) References cited:
- WO-A-00/79570
- DE-A- 19 944 144
- US-A- 5 523 589
- US-B1- 6 187 606
- CAMPOS F J ET AL: "CONFOCAL MICRO-RAMAN CHARACTERIZATION OF LATTICE DAMAGE IN HIGH ENERGY ALUMINUM IMPLANTED 6H-SIC" JOURNAL OF APPLIED PHYSICS, AMERICAN INSTITUTE OF PHYSICS. NEW YORK, US, vol. 85, no. 1, 1999, pages 99-104, XP000823005 ISSN: 0021-8979
- SCOTT M B ET AL: "HIGH TEMPERATURE (500øC) IMPLANTATION STUDY OF P+ AND N+ IMPLANTED EPITAXIAL N-TYPE 4H-SIC" COMPOUND SEMICONDUCTORS 1998. PROCEEDINGS OF THE 25TH INTERNATIONAL SYMPOSIUM ON COMPOUND SEMICONDUCTORS. NARA, JAPAN, OCT. 12 - 16, 1998, INSTITUTE OF PHYSICS CONFERENCE SERIES, LONDON: IOP, GB, vol. NR. 162, 12 October 1998 (1998-10-12), pages 763-768, XP000895301 ISBN: 0-7503-0611-4
- OHTA I ET AL: "AN IDEAL-PROFILE IMPLANTATION PROCESS FOR GAAS ANALOG MMICS" PROCEEDINGS OF THE GALLIUM ARSENIDE INTEGRATED CIRCUIT SYMPOSIUM (GAAS IC) GRENELEFE, FLORIDA, OCT. 28 - 30, 1986, NEW YORK, IEEE, US, vol. SYMP. 8, October 1986 (1986-10), pages 55-58, XP000842027
- DUNCAN W M ET AL: "A SINGLE STEP SELECTIVE IMPLANTATION TECHNOLOGY FOR MULTIPLE DOPED LAYERS USING PROXIMITY ANNEALING" IEEE ELECTRON DEVICE LETTERS, IEEE INC. NEW YORK, US, vol. EDL-2, no. 12, December 1981 (1981-12), pages 309-311, XP000819033 ISSN: 0741-3106
- HOVEL H J: "IMPLANT PROFILE ADJUSTMENT WITH GAALAS CAPS" IBM TECHNICAL DISCLOSURE BULLETIN, IBM CORP. NEW YORK, US, vol. 27, no. 9, February 1985 (1985-02), pages 5360-5361, XP000807822 ISSN: 0018-8689

## Description

### Background

To date, the most successful materials for producing light emitting devices or "LEDs" (including light emitting diodes, laser diodes, photodetectors and the like) capable of operation in the UV, blue and green portions of the electromagnetic spectrum have been the group III-nitride compound semiconductor materials, and in particular gallium nitride-based compound semiconductors. However, gallium nitride presents a particular set of technical problems in manufacturing working devices. The primary problem is the lack of bulk single crystals of gallium nitride which in turn means that gallium nitride or other group III-nitride devices must be formed as epitaxial layers on other materials. Sapphire (*i.e.,* aluminum oxide or Al₂O₃) has been commonly used as a substrate for group III-nitride devices. Sapphire offers a reasonable crystal lattice match to Group III nitrides, thermal stability, and transparency, all of which are generally useful in producing a light emitting diode. Sapphire offers the disadvantage, however, of being an electrical insulator. This means that the electric current that is passed through an LED to generate the emission cannot be directed through the sapphire substrate. Thus, other types of connections to the LED must be made, such as placing both the cathode and anode of the device on the same side of the LED chip in a so-called "horizontal" configuration. In general, it is preferable for an LED to be fabricated on a conductive substrate so that ohmic contacts can be placed at opposite ends of the device. Such devices, called "vertical" devices, are preferred for a number of reasons, including their easier manufacture as compared to horizontal devices.

In contrast to sapphire, silicon carbide can be conductively doped, and therefore can be effectively used to manufacture a vertical group III-nitride LED. In addition, silicon carbide has a relatively small lattice mismatch with gallium nitride, which means that high-quality group III-nitride material can be grown on it. Silicon carbide also has a high coefficient of thermal conductivity, which is important for heat dissipation in high-current devices such as laser diodes.

Examples of silicon carbide-based group III-nitride LEDs are shown in U.S. Patents 5,523,589; 6,120,600; and 6,187,606 each of which is assigned to Cree, Inc., the assignee of the present invention. Such devices typically comprise a silicon carbide substrate, a buffer layer or region formed on the substrate, and a plurality of group III-nitride layers forming a p-n junction active region.

In particular, U.S. Patent No. 6,187,606 represents an important advance over the state of the art as it previously existed. The invention described in the '606 patent provided a plurality of discrete crystal portions, or "dots", of GaN or InGaN on the substrate in an amount sufficient to minimize or eliminate the heterobarrier between the substrate and the buffer layer. A highly conductive path between the substrate and the active region could thereby be established.

An important parameter for LEDs is the forward voltage (V_{f}) drop between the anode and the cathode of the device during forward bias operation. In particular, it is desirable for the forward voltage (V_{f}) of a device to be as low as possible to reduce power consumption and increase the overall efficiency of the device. Despite the advance of the '606 patent, there remains a measurable voltage drop at the interface between a conventional silicon carbide substrate and the conductive buffer layer. It is desirable to reduce this voltage drop in order to reduce the overall V_{f} of the resulting device.

According to a first aspect of the invention there is provided a method of treating a silicon carbide substrate for improved epitaxial deposition thereon and for use as a precursor in the manufacture of devices such as light emitting diodes, the method comprising:
forming a capping layer of silicon dioxide on a first surface of a conductive silicon carbide wafer having a first conductivity type, wherein the capping layer is formed to a thickness of 50 nm;
implanting dopant atoms of the same conductivity as the silicon carbide wafer into and through the capping layer and the first surface of the silicon carbide wafer in a first dose with a dopant concentration of between 4E12 cm⁻² and 1E15 cm⁻² at an implant energy of 25 keV and a second dose with a dopant concentration of between 7E12 cm⁻² and 1.8E15 cm⁻² at an implant energy of 50 keV to form a dopant profile;
annealing the implanted wafer;
removing the capping later; and
growing an epitaxial layer on the implanted first surface of the silicon carbide substrate wafer.

The invention also provides a silicon carbide structure comprising:
a silicon carbide wafer having a first surface and a second surface and having a predetermined conductivity type and an initial carrier concentration;
a region of dopant atoms extending from said first surface into said silicon carbide wafer to a predetermined depth, said region having a higher carrier concentration than said initial carrier concentration in the remainder of said wafer, wherein said region of dopant atoms has a concentration of dopant atoms of 1E21 cm⁻³ extending from said first surface into the silicon carbide wafer to a depth of 50 nm; and
an epitaxial layer on said first surface of said silicon carbide wafer.

Devices according to embodiments of the present invention include a light emitting device comprising a silicon carbide substrate having a predetermined conductivity type and first and second surfaces, a conductive buffer layer on the first surface of the substrate, and an active region on the conductive buffer, wherein the first surface of the substrate has a first implantation profile of implanted dopants of the predetermined conductivity type adjacent the first surface.
Figure 1 shows a simplified schematic of a silicon carbide-based LED;
Figure 2 illustrates a first method of fabrication of doped structures;
Figure 3 illustrates a second method of fabrication of doped structures, wherein a capping layer is deposited on a surface of the substrate prior to dopant implantation;
Figure 4 shows a schematic of a desired depth profile that could be formed according to the method illustrated in Figure 2;
Figure 5 shows a schematic of the desired depth profile that could be formed according to the method illustrated in Figure 3; and
Figure 6 shows a plot of interfacial voltage against implantation dosage.

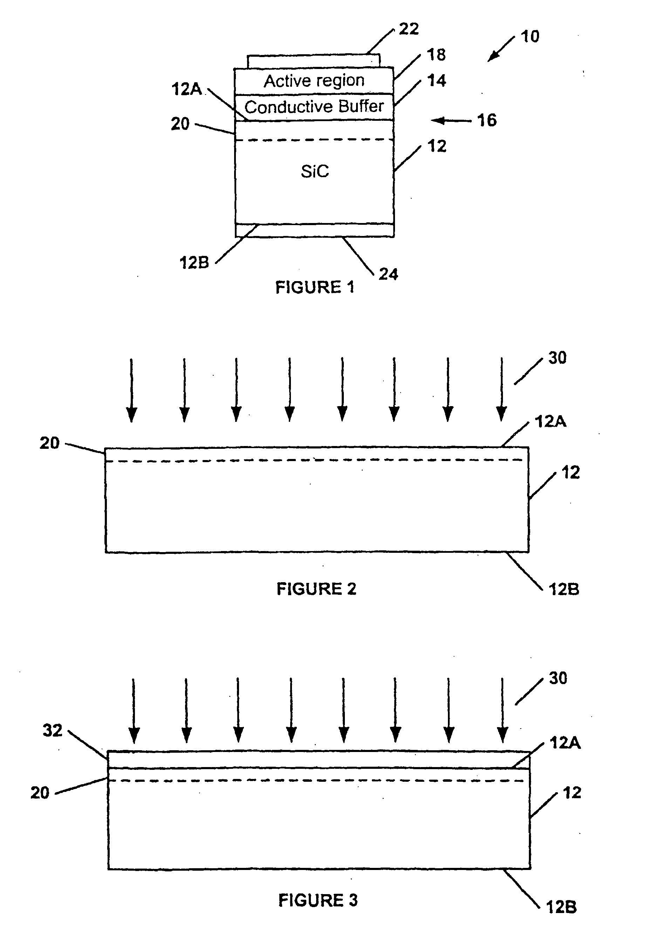

Referring to FIG. 1 which shows a simplified schematic of a silicon carbide-based LED which may be made according to the present invention, device 10 comprises a conductive silicon carbide substrate 12 having a first conductivity type and having a first surface 12A and a second surface 12B. Device 10 further includes a conductive buffer region 14 formed on surface 12A of substrate 12 and an active region 18 formed on the conductive buffer 14. Active region 18 preferably includes a p-n junction and most preferably comprises a single heterostructure, double heterostructure, single quantum well, multiple quantum well or the like. A first ohmic contact 22 is formed on the surface of the active region. A second ohmic contact 24 is formed on the surface of the substrate. In a preferred embodiment, substrate 12 comprises n-type 4H-silicon carbide. Accordingly, in a preferred embodiment ohmic contact 22 comprises the anode of the device 10 while ohmic contact 24 comprises the cathode of the device 10. Ohmic contact 24 may be formed according to the methods described in U.S. Patent Application Serial No. 09/787,189 filed March 15, 2001 published as US 688464 on 25 April 2005. Substrate 12 includes a first implanted region 20 adjacent to surface 12A and comprising implanted dopant atoms of the first conductivity type. The presence of implanted region 20 causes a reduction in the voltage drop observable at the interface between substrate 12 and buffer region 14, which results in a reduction in the overall forward operating voltage (V_{f}) of the device 10. The implanted region has a peak concentration of implanted dopant atoms of between about 1E19 and 5E21 cm⁻³ and is between about 1 and 500 nm thick. Preferably, the implanted region has a peak concentration of implanted dopant atoms of about 1E21 cm⁻³ and is about 50 nm thick.

FIG. 2 illustrates a method of fabrication of doped structures. A silicon carbide substrate 12 is provided having a first conductivity type and having first surface 12A and second surface 12B. The fabrication of doped silicon carbide substrates such as substrate 12 is well known in the art. For example, U.S. Patent RE34,861 discloses a process for growing boules of silicon carbide via controlled seeded sublimation. The resulting silicon carbide crystal may exhibit one of a number of polytypes, such as 4H, 6H, 15R or others. N-type dopants such as nitrogen and/or phosphorus or p-type dopants such as aluminum and/or boron may be incorporated into the crystal during growth to impart a net n-type or p-type conductivity, respectively. The crystal boules are then sliced into wafers which are chemically and mechanically treated (polished) to provide a suitable substrate for the growth of epitaxial layers and the fabrication of electronic devices thereon.

Substrate 12 may comprise n-type 4H or 6H-silicon carbide doped with nitrogen donor atoms at a net dopant concentration of about 5E17 to 3E18 cm⁻². Subsequent to wafering and polishing, dopant atoms 30 of a predetermined conductivity type are implanted into surface 12A of substrate 12 at one or more predetermined dopant concentrations and implant energies to form a dopant profile in implanted region 20 of substrate 12. Preferably, dopant atoms 30 have the same conductivity type as substrate 12. That is, if substrate 12 is n-type, then dopants 30 comprise a dopant such as nitrogen and/or phosphorus that imparts n-type conductivity in silicon carbide. Alternatively, if substrate 12 is p-type, then dopants 30 comprise a dopant such as boron or aluminum that imparts p-type conductivity in silicon carbide.

Dopants 30 are implanted into substrate 12 through surface 12A according to a predetermined implant dose and energy level. Implantation may be performed in one step at a single dose and energy level or in a plurality of steps at multiple doses and/or multiple energy levels. Implantation may be performed via a plurality of implant doses and energy levels in order to impart a relatively flat implantation profile to a predetermined depth within substrate 12. For example, in one method, a 6H-silicon carbide substrate is implanted with phosphorus atoms at a first dose of 2E15 cm⁻² and an energy of 25 keV and a second dose of 3.6E15 cm⁻² at an energy of 50 keV.

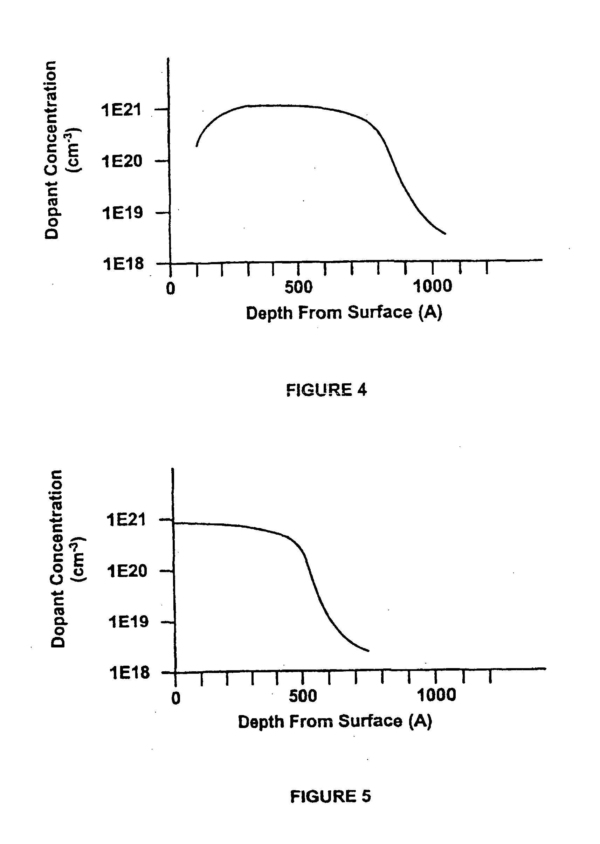

A schematic of a desired depth profile that could be formed according to this method is shown the graph of FIG. 4. The graph of FIG. 4 shows the profile of implanted atoms in atoms/cm³ (y-axis) as a function of depth in angstroms from the first surface 12A of substrate 12 (x-axis). As shown in FIG. 4, the implant profile increases to a maximum of about 1E21 cm⁻³ at a depth of about 300 Å (30 nm). From there, the profile stays relatively flat to a depth of about 800 Å (80 nm), and then begins to drop off to background levels. Accordingly, implanted region 20 may be said to extend from surface 12A into substrate 12 for a depth of 800-1000 Å (80-100 nm).

Following the implantation, the substrate is annealed in a standard tube anneal in Argon at a temperature of 1300° for 90 minutes to activate the implanted dopants. A range of temperatures is also effective for annealing, with 1300° being exemplary rather than limiting.

A conductive buffer 14 may then formed on surface 12A of substrate 12.

One drawback of this method is that the dopant profile tends to reach its maximum at some depth within the substrate, determined by the implant doses and energies. That is, the implant concentration at the surface is less than the maximum concentration within the substrate. Implanted dopant concentrations must be kept at less than about 5E21 cm⁻³ or else the implanted atoms will cause unwanted and irreparable damage to the crystal lattice of substrate 12.

In order to provide the maximum improvement in voltage drop, it is desirable to have the implant concentration at the surface at the surface of the substrate at as high a level as possible, *i.e*., the implant concentration at the surface should be around 1E21 cm⁻³. However, in order to achieve such a surface concentration according to the embodiment of FIG. 2, it would be necessary to implant the dopant atoms at a dose and energy level that would produce dopant concentrations within the substrate that would damage the substrate as described above.

Accordingly, in an embodiment of the invention illustrated in FIG. 3, a capping layer 32 is deposited on surface 12A of substrate 12 prior to dopant implantation. The capping layer 32 comprises a silicon dioxide layer deposited using Plasma-Enhanced Chemical Vapor Deposition (PECVD) or grown as a thermal oxide, both of which are well known processes capable for depositing oxide layers of precise thickness and composition.

The thickness of capping layer 32 and the implantation parameters (dose and energy) are selected such that the maximum implant concentration resulting from the implantation step occurs at or near the surface 12A of the substrate 12 (*i.e*., at or near the interface between substrate 12 and capping layer 32). The resulting structure is then annealed in a standard tube anneal in argon at a temperature of 1300°C for 90 minutes to activate the implanted dopants. Capping layer 32 is removed using conventional techniques. For example, if capping layer 32 comprises a PECVD oxide layer, it may be removed with a wet chemical etch process. The resulting structure then ideally comprises a substrate 12 having an implanted region 20 wherein the peak concentration of implanted atoms in the implanted region 20 occurs at or near surface 12A of substrate 12.

A schematic of the desired depth profile that could be formed according to this embodiment is shown the graph of FIG. 5. The graph of FIG. 5 shows a schematic profile of implanted atoms in atoms/cm3 (y-axis) as a function of depth in angstroms from the first surface 12A of substrate 12. As shown in FIG. 5, the implant profile is approximately 1E21 cm⁻³ at the surface 12A of the substrate 12. From there, the profile stays relatively flat for a depth of about 500 Å (50 nm), and then begins to drop off to background levels.

In one embodiment, a silicon dioxide layer 32 having a thickness of about 50 nm is formed via PECVD on surface 12A of substrate 12. Nitrogen atoms are implanted into the oxide layer and the substrate 12 in a first dose at an implant energy of 25 keV and a second dose at an implant energy of 50 keV. The first implant may have a dose of 4E12 cm⁻² to 1E15 cm⁻², while the second implant may have a dose of 7E12 cm⁻² to 1.8E15 cm⁻².

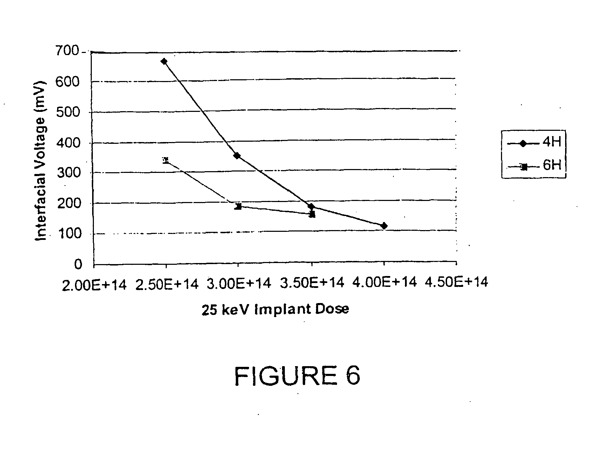

A graph of the interfacial voltage (V_{f}) at the substrate/buffer region interface versus 25keV implant dose is shown in Figure 6. To generate the data shown in Figure 6, sample 4H and 6H silicon carbide wafers having a net concentration of nitrogen dopants of between 3.3E17 and 2.1E18 cm⁻³ were employed. A 50 nm thick PECVD silicon dioxide layer was formed on the surface of the wafers, and the wafers were implanted with various controlled doses of nitrogen at energy levels of 25keV and 50 keV respectively. The implant doses and energy levels for each wafer are shown in Table 1.

| Table 1 | | | | |
|---|---|---|---|---|
| Wafer | Type | Dopant | 25 keV Dose (cm⁻²) | 50 keV Dose (cm⁻²) |
| | | | | |
| A | 4H | 28N2+ | 2.5E14 | 4.38E14 |
| B | 4H | 28N2+ | 3.0E14 | 5.25E14 |
| C | 4H | 28N2+ | 3.5E14 | 6.13E14 |
| D | 4H | 28N2+ | 4.0E14 | 7.0E14 |
| E | 6H | 28N2+ | 2.5E14 | 4.38E14 |
| F | 6H | 28N2+ | 3.0E14 | 5.25E14 |
| G | 6H | 28N2+ | 3.5E14 | 6.13E14 |

Conductive buffers were then formed on the implanted substrates. The interfacial voltage (*i.e.,* the voltage drop attributable to the substrate/buffer interface) was measured at three locations on the wafer and an average value was calculated. The average values are plotted against the 25 keV implant dose in Figure 6. As shown in Figure 6, the interfacial voltage of the substrate/buffer interface decreases with increasing dosage.

## Claims

1. A method of treating a silicon carbide substrate (12) for improved epitaxial deposition thereon and for use as a precursor in the manufacture of devices, the method comprising:
forming a capping layer (32) of silicon dioxide on a first surface (12A) of a conductive silicon carbide wafer having a first conductivity type, wherein the capping layer is formed to a thickness of 50 nm;
implanting dopant atoms of the same conductivity type as the silicon carbide wafer into and through the capping layer and the first surface of the silicon carbide wafer in a first dose with a dopant concentration of between 4E12 cm⁻² and 1E15cm⁻² at an implant energy of 25 keV and a second dose with a dopant concentration of between 7E12cm⁻² and 1.8E15cm⁻² at an implant energy of 50keV to form a dopant profile;
annealing the implanted wafer;
removing the capping layer; and
growing an epitaxial layer on the implanted first surface of the silicon carbide substrate wafer.

2. A method according to claim 1 of forming a light emitting diode further comprising the steps of:
forming a conductive buffer region on the implanted first surface of the silicon carbide wafer;
forming an active region on the conductive buffer region;
forming a first ohmic contact on said active region; and
forming a second ohmic contact on the second surface of said silicon carbide wafer.

3. The method according to claim 1 or 2 wherein the step of implanting dopant atoms imparts a flat implantation profile to a predetermined depth within the wafer.

4. The method according to claim 3 wherein the implanting step comprises implanting dopant atoms in the implant region to a concentration of implanted dopant atoms of between 1E19 and 5E21 cm⁻³.

5. The method according to claim 3 wherein the implanting step comprises implanting dopant atoms in the implant region to a concentration of implanted dopant atoms of 1E21 cm⁻³ and to a depth within the silicon carbide wafer of 50 nm.

6. The method according to claim 1 or 2 wherein the implanted wafer is annealed in Argon at a temperature of 1300°C for 90 minutes.

7. The method according to claim 1 or 2 comprising implanting dopant atoms selected from nitrogen and phosphorus into an n-type silicon carbide wafer.

8. The method according to claim 1 or 2 comprising implanting dopant atoms selected from the group consisting of boron and aluminum into a p-type silicon carbide wafer.

9. The method according to claim 1 comprising depositing the capping layer on the silicon carbide wafer using plasma-enhanced chemical vapor deposition.

10. The method according to claim 1 comprising removing the capping layer with a wet chemical etch process.

11. The method according to claim 2 further comprising the step of fabricating the active layer from the group consisting of single heterostructures, double heterostructures, single quantum wells, multiple quantum wells and combinations thereof.

12. A silicon carbide structure comprising:
a silicon carbide wafer (12) having a first surface (12A) and a second surface (12B) and having a predetermined conductivity type and an initial carrier concentration except where indicated below;
a region (20) of dopant atoms extending from said first surface into said silicon carbide wafer to a predetermined depth, said region having a higher carrier concentration than said initial carrier concentration in the remainder of said wafer, wherein said region of dopant atoms has a concentration of dopant atoms of 1E21 cm⁻³ extending from said first surface into said silicon carbide wafer to a depth of 50 nm; and
an epitaxial layer on said first surface of said silicon carbide wafer.

13. A silicon carbide structure according to claim 12 wherein said silicon carbide wafer comprises n-type 6H-silicon carbide or n-type 4H-silicon carbide.

14. A silicon carbide structure according to claim 12 wherein said region of dopant atoms comprises phosphorus.

15. A light emitting diode (10) incorporating the substrate of any one of claims 12 to 14 and further comprising:
a conductive buffer region on said first surface of said conductive silicon carbide wafer;
an active region on said conductive buffer region;
a first ohmic contact to said active region; and
a second ohmic contact on the second surface of said silicon carbide wafer.

16. An LED according to claim 15 wherein said active layer is a single heterostructure, a double heterostructure, a single quantum well, a multiple quantum wellor a combinations thereof.

## Patentansprüche

1. Verfahren zur Bearbeitung eines Siliciumcarbidsubstrats (12) für eine Verbesserung einer epitaktischen Abscheidung darauf und für eine Verwendung als Vorprodukt bei der Herstellung von Bauelementen, wobei das Verfahren umfasst:
Ausbilden einer Deckschicht (32) aus Siliciumdioxid auf einer ersten Oberfläche (12A) eines leitfähigen Siliciumcarbidwafers einer ersten Leitungsart, wobei die Deckschicht mit einer Dicke von 50 nm ausgebildet ist,
Implantieren von Dotierstoffatomen, deren Leitungsart der des Siliciumcarbidwafers entspricht, in und durch die Deckschicht und die erste Oberfläche des Siliciumcarbidwafers mit einer ersten Dosis der Dotierstoffkonzentration von 4 · 1012 cm⁻² bis 1 · 10¹⁵ cm⁻² und einer Implantationsenergie von 25 keV sowie einer zweiten Dosis der Dotierstoffkonzentration von 7 · 1012 cm⁻² bis 1,8 · 1015 cm⁻² und einer Implantationsenergie von 50 keV, um ein Dotierstoffprofil auszubilden,
Ausheilen des implantierten Wafers,
Entfernen der Deckschicht und
Abscheiden einer Epitaxieschicht auf der implantierten ersten Oberfläche des Siliciumcarbidwafers.

2. Verfahren nach Anspruch 1 zur Ausbildung einer Licht emittierenden Diode, wobei das Verfahren ferner Schritte umfasst zum:
Ausbilden einer leitfähigen Pufferzone auf der implantierten ersten Oberfläche des Siliciumcarbidwafers,
Ausbilden einer aktiven Zone auf der leitfähigen Pufferzone,
Ausbilden eines ersten ohmschen Kontakts auf der aktiven Zone und
Ausbilden eines zweiten ohmschen Kontakts auf der zweiten Oberfläche des Siliciumcarbidwafers.

3. Verfahren nach Anspruch 1 oder 2, worin der Schritt zum Implantieren von Dotierstoffatomen zu einem flachen Implantationsprofil vorgegebener Tiefe in dem Wafer führt.

4. Verfahren nach Anspruch 3, worin der Implantationsschritt ein Implantieren von Dotierstoffatomen in die Implantationszone bis zu einer Konzentration der implantierten Dotierstoffatome von 1 · 1019 bis 5 · 1021 cm⁻³ umfasst.

5. Verfahren nach Anspruch 3, worin der Implantationsschritt ein Implantieren von Dotierstoffatomen in die Implantationszone bis zu einer Konzentration der implantierten Dotierstoffatome von 1 · 10²¹ cm⁻³ und bis in eine Tiefe des Siliciumcarbidwafers von 50 nm umfasst.

6. Verfahren nach Anspruch 1 oder 2, worin der implantierte Wafer 90 Minuten lang in Argon bei einer Temperatur von 1300 °C ausgeheilt wird.

7. Verfahren nach Anspruch 1 oder 2, das ein Implantieren von Dotierstoffatomen in einen n-leitenden Siliciumcarbidwafer umfasst, die unter Stickstoff und Phosphor ausgewählt sind.

8. Verfahren nach Anspruch 1 oder 2, das ein Implantieren von Dotierstoffatomen in einen p-leitenden Siliciumcarbidwafer umfasst, die unter Bor und Aluminium ausgewählt sind.

9. Verfahren nach Anspruch 1, das ein Abscheiden einer Deckschicht auf dem Siliciumcarbidwafer unter Verwendung einer plasmaunterstützten chemischen Gasphasenabscheidung umfasst.

10. Verfahren nach Anspruch 1, das ein Entfernen der Deckschicht mithilfe eines nasschemischen Ätzvorgangs umfasst.

11. Verfahren nach Anspruch 2, das ferner einen Schritt zum Herstellen der aktiven Schicht aus der Gruppe der einzelnen Heterostrukturen, Doppelheterostrukturen, einzelnen Quantentöpfe, Mehrfachquantentöpfe und deren Kombinationen umfasst.

12. Siliciumcarbidstruktur, die aufweist:
einen Siliciumcarbidwafer (12) mit einer ersten Oberfläche (12A) und einer zweiten Oberfläche (12B), der einen vorgegebenen Leitungstyp und, sofern nachfolgend nicht anders angegeben,
eine anfängliche Ladungsträgerkonzentration aufweist,
eine Zone (20) mit Dotierstoffatomen, die sich von der ersten Oberfläche bis zu einer vorgegebenen Tiefe in den Siliciumcarbidwafer hinein erstreckt, wobei die Ladungsträgerkonzentration in der Zone höher ist als im übrigen Teil des Wafers und die Zone mit den Dotierstoffatomen eine Konzentration an Dotierstoffatomen von 1 1021 cm⁻³ aufweist,
die sich von der ersten Oberfläche bis in eine Tiefe des Siliciumcarbidwafers von 50 nm erstrecken, und
eine Epitaxieschicht, die sich auf der ersten Oberfläche des Siliciumcarbidwafers befindet.

13. Siliciumcarbidstruktur nach Anspruch 12, worin der Siliciumcarbidwafer ein n-leitendes 6H-Siliciumcarbid oder ein n-leitendes 4H-Siliciumcarbid aufweist.

14. Siliciumcarbidstruktur nach Anspruch 12, worin die Zone mit Dotierstoffatomen Phosphor aufweist.

15. Licht emittierende Diode (10), die ein Substrat nach einem der Ansprüche 12 bis 14 umfasst und ferner aufweist:
eine leitfähige Pufferzone, die sich auf der ersten Oberfläche des leitfähigen Siliciumcarbidwafers befindet,
eine aktive Zone, die sich auf der leitfähigen Pufferzone befindet, einen ersten ohmschen Kontakt zur aktiven Zone und
einen zweiten ohmschen Kontakt, der sich auf der zweiten Oberfläche des Siliciumcarbidwafers befindet.

16. LED nach Anspruch 15, worin die aktive Zone eine einzelne Heterostruktur, eine Doppelheterostruktur, ein einzelner Quantentopf, ein Mehrfachquantentopf oder eine Kombination hiervon ist.

## Revendications

1. Procédé de traitement d'un substrat de carbure de silicium (12) pour un dépôt épitaxial amélioré sur celui-ci et pour l'utilisation comme un précurseur dans la fabrication de dispositifs, le procédé comprenant :
former une couche de recouvrement (32) en dioxyde de silicium sur une première surface (12A) d'une tranche de carbure de silicium conductrice d'un premier type de conductivité, où la couche de recouvrement est réalisée en une épaisseur de 50 nm ;
implanter des atomes dopants du même type de conductivité que la tranche de carbure de silicium dans et à travers la couche de recouvrement et la première surface de la tranche de carbure de silicium en une première dose avec une concentration de dopant comprise entre 4E12 cm⁻² et 1E15 cm⁻² à une énergie d'implantation de 25 keV, et une deuxième dose d'une concentration de dopant comprise entre 7E12 cm⁻² et 1,8E15 cm⁻² à une énergie d'implantation de 50 keV pour former un profil de dopant ;
recuire la tranche implantée ;
retirer la couche de recouvrement ; et
faire croître une couche épitaxiale sur la première surface implantée de la tranche de substrat de carbure de silicium.

2. Procédé selon la revendication 1 de formation d'une diode émettrice de lumière, comprenant en outre les étapes de :
former une région de tampon conductrice sur la première surface implantée de la tranche de carbure de silicium ;
former une région active sur la région de tampon conductrice ;
former un premier contact ohmique sur ladite région active ; et
former un deuxième contact ohmique sur la seconde surface de ladite tranche de carbure de silicium.

3. Procédé selon la revendication 1 ou 2, dans lequel l'étape d'implantation d'atomes dopants confère un profil d'implantation plat à une profondeur prédéterminée dans la tranche.

4. Procédé selon la revendication 3, dans lequel l'étape d'implantation comprend l'implantation d'atomes dopants dans la région d'implantation à une concentration d'atomes dopants implantés entre 1E19 et 5E21 cm⁻³.

5. Procédé selon la revendication 3, dans lequel l'étape d'implantation comprend l'implantation d'atomes dopants dans la région d'implantation à une concentration d'atomes dopants implantés de 1E21 cm⁻³ et à une profondeur dans la tranche de carbure de silicium de 50 nm.

6. Procédé selon la revendication 1 ou 2, dans lequel la tranche implantée est recuite dans de l'argon à une température de 1300°C pendant 90 minutes.

7. Procédé selon la revendication 1 ou 2 comprenant l'implantation d'atomes dopants sélectionnés parmi azote et phosphore dans une tranche de carbure de silicium de type n.

8. Procédé selon la revendication 1 ou 2 comprenant l'implantation d'atomes dopants sélectionnés dans le groupe consistant en bore et aluminium dans une tranche de carbure de silicium de type p.

9. Procédé selon la revendication 1, comprenant le dépôt de la couche de recouvrement sur la tranche de carbure de silicium en utilisant le dépôt chimique en phase vapeur activé par plasma.

10. Procédé selon la revendication 1, comprenant le retrait de la couche de recouvrement avec un procédé d'attaque chimique humide.

11. Procédé selon la revendication 2, comprenant en outre l'étape consistant à fabriquer la couche active à partir du groupe consistant en hétéro-structures simples, hétéro-structures doubles, puits quantiques uniques, puits quantiques multiples et leurs combinaisons.

12. Structure de carbure de silicium, comprenant :
une tranche de carbure de silicium (12) ayant une première surface (12A) et une seconde surface (12B) et ayant un type de conductivité prédéterminée et une concentration de porteurs initiale à l'exception des emplacements indiqués ci-dessous ;
une région (20) d'atomes dopants s'étendant de ladite première surface dans ladite tranche de carbure de silicium à une profondeur prédéterminée, ladite région ayant une concentration de porteurs plus élevée que ladite concentration de porteurs initiale dans le restant de ladite tranche, où ladite région d'atomes dopants a une concentration d'atomes dopants de 1E21 cm⁻³ s'étendant depuis ladite première surface dans ladite tranche de carbure de silicium à une profondeur de 50 nm ; et
une couche épitaxiale sur ladite première surface de ladite tranche de carbure de silicium.

13. Structure de carbure de silicium selon la revendication 12, dans laquelle ladite tranche de carbure de silicium comprend un carbure de silicium 6H de type n ou carbure de silicium 4H de type n.

14. Structure de carbure de silicium selon la revendication 12, dans laquelle ladite région d'atomes dopants comprend du phosphore.

15. Diode émettrice de lumière (10) incorporant le substrat selon l'une quelconque des revendications 12 à 14 et comprenant en outre :
une région tampon conductrice sur ladite première surface de ladite tranche de carbure de silicium conductrice ;
une région active sur ladite région tampon conductrice ;
un premier contact ohmique à ladite région active ; et
un deuxième contact ohmique sur la seconde surface de ladite tranche de carbure de silicium.

16. DEL selon la revendication 15, dans laquelle ladite couche active est une hétéro-structure simple, une hétéro-structure double, un puits quantique unique, un puits quantique multiple ou leurs combinaisons.
